# EUROPÄISCHE PATENTSCHRIFT

(11) **EP 2 645 571 B1**
(45) Veröffentlichungstag und Bekanntmachung des Hinweises auf die Patenterteilung: **23.01.2019**
(21) Anmeldenummer: 12161377.2
(22) Anmeldetag: 27.03.2012
(51) Int. Cl.: H03K 17/96

(54) **Kapazitive Schaltvorrichtung**
Capacitative circuit
Dispositif de commutation capacitif

(43) Veröffentlichungstag der Anmeldung: 02.10.2013
(73) Patentinhaber: RAFI GmbH & Co. KG, 88276 Berg (DE)
(72) Erfinder: Bulach, Eric, 88074 Meckenbeuren (DE)
(74) Vertreter: Engelhardt, Volker

(56) Entgegenhaltungen:
- EP-A1- 2 372 914
- DE-A1-102009 042 244
- DE-U1-202011 050 761

## Beschreibung

Die Erfindung bezieht sich auf eine kapazitive Schaltvorrichtung zur Erzeugung eines elektrisch auswertbaren Schaltsignals nach dem Oberbegriff des Patentanspruches 1.

Solche Schaltvorrichtungen sind als Bedienhilfe für Werkzeugmaschinen oder elektrische Geräte, beispielsweise Handys, bekannt. Eine kapazitive Berührungseinrichtung ist z.B. in der Gebrauchsmusterschrift DE 20 2011 050 761 (LITE-ON TTechnology Corp.) offenbart. Um die einzelnen Schaltflächen zu visualisieren, sind diese ausgeleuchtet. Da jedoch das von dem Sensor abgestrahlte elektrische Feld möglichst nahe an der Abdeckplatte anzubringen ist, um das derart erzeugte elektrische Feld durch diese hindurchzuleiten, werden sogenannte ITO-Folien auf die Unterseite der Abdeckplatte aufgeklebt. Ein Beleuchtungsmittel wird anschließend, beispielsweise auf einer Leiterplatte angebracht und durchleuchtet die durchsichtige ITO-Folie.

Als nachteilig hat sich herausgestellt, dass die verwendeten ITO-Folien in ihrer Herstellung äußerst kostenintensiv sind und dadurch erhöhte Produktionskosten entstehen, sobald die ITO-Folien zu verwenden sind.

Darüber hinaus können die ITO-Foliensensoren ausschließlich in einem vorgegebenen Temperaturbereich benutzt werden, da unter- oder oberhalb einer bestimmten Temperatur die Funktionsweise dieser ITO-Foliensensoren eingeschränkt ist.

Darüber hinaus sind solche ITO-Foliensensoren auf eine Frontglasplatte, die als Abdeckung dient, aufzulaminieren. Um eine homogene Ausleuchtung der ITO-Foliensensoren zu erreichen, ist oftmals ein Reflektor vorzusehen, so dass dadurch die Produktionskosten gesteigert sind.

Es ist daher Aufgabe der Erfindung, eine Schaltvorrichtung der eingangs genannten Gattung bereitzustellen, die eine Vielzahl von unterschiedlich ausgeleuchteten Schaltflächen aufweist und deren Produktionskosten gegenüber der Verwendung von sogenannten ITO-Foliensensoren erheblich reduziert ist.

Diese Aufgabe wird erfindungsgemäß durch die Merkmale des kennzeichnenden Teils von Patentanspruch 1 gelöst.

Weitere vorteilhafte Weiterbildungen der Erfindung ergeben sich aus den Unteransprüchen.

Dadurch, dass die Beleuchtungsmittel zwischen der Sensorfläche und der Unterseite der Abdeckplatte angeordnet sind, kann auf die Verwendung von ITO-Foliensensoren verzichtet werden. Es ist ausreichend, eine metallische Schicht als Sensorfläche auf eine Leiterplatte aufzudrucken bzw. anzubringen, durch die ein nach außen abstrahlendes elektrisches Feld erzeugt wird.

Darüber hinaus ist es vorteilhaft, wenn zur homogenen Ausleuchtung der jeweiligen Schaltfläche im Bereich der Beleuchtungsmittel, also zwischen der Sensorfläche und der Abdeckplatte ein Lichtwellenleiter, beispielsweise in Form einer dünnwandigen Kunststoffplatte, vorgesehen ist und wenn die Beleuchtungsmittel seitlich neben dem Lichtwellenleiter in dessen unmittelbarem Randbereich angeordnet sind. Die von den Sensorflächen erzeugten elektrischen Felder durchdringen dabei die Lichtwellenleiter und die Abdeckplatte und somit strahlen nach außen ab, so dass beispielsweise durch das Eindringen eines menschlichen Fingers eine Veränderung des elektrischen Feldes auf der Schaltfläche stattfindet.

Darüber hinaus kann die Unterseite der Abdeckplatte mit einer Farbe beschichtet sein, durch die die emittierten Lichtwellen reflektiert oder absorbiert sind, so dass visuell voneinander getrennte Schaltflächen entstehen.

Es ist besonders vorteilhaft, wenn auf der Leiterplatte fluchtend zu der jeweiligen Farbschicht und zur Begrenzung der jeweiligen Schaltfläche Kondensatoren oder Trennkörper, beispielsweise in Form eines Klebers, aufgebracht sind, durch die die Lichtwellen reflektiert und/oder absorbiert sind, so dass diese ausschließlich im Bereich der jeweiligen Schaltfläche von außen erkennbar sind. Somit ist die Schaltfläche optimal und homogen ausgeleuchtet.

Ferner können die Beleuchtungsmittel mit einer elektrischen Steuereinrichtung gekoppelt sein, durch die die Beleuchtungsmittel ein- oder ausgeschaltet sind oder durch die der Farbton der jeweiligen Beleuchtungsmittel veränderbar ist, und zwar in Abhängigkeit von dem jeweiligen Schaltzustand der jeweiligen Schaltfläche.

In der Zeichnung ist ein erfindungsgemäßes Ausführungsbeispiel einer Schaltvorrichtung mit unterschiedlichen Anordnungen von Lichtwellenleitern dargestellt, die nachfolgend näher erläutert ist. Im Einzelnen zeigt:
- Figur 1a: eine Schaltvorrichtung mit einer Leiterplatte, auf der eine Sensorfläche aufgedruckt ist und mit einer Vielzahl von Beleuchtungsmitteln, die seitlich versetzt zu einem Lichtwellenleiter oberhalb der Sensorfläche angeordnet sind, und durch die eine von einer Abdeckplatte aus Glas gebildeten Schaltfläche beleuchtet ist,
- Figur 1b: die Schaltvorrichtung mit X/Y-Auswertesystem gemäß Figur 1a mit einem durchgehenden Lichtwellenleiter und umlaufend um die jeweiligen Beleuchtungsmittel angeordneten Absorbtionskörper,
- Figur 2a: die Schaltvorrichtung gemäß Figur 1a in Draufsicht mit einem elektrischen Schaltplan,
- Figur 2b: die Schaltvorrichtung mit fester Zuordnung der Sensorfläche zum Auswertesystem gemäß Figur 1b in Draufsicht mit einem elektrischen Schaltplan,
- Figur 3: die Schaltvorrichtung gemäß Figur 1b und den Verläufen der Lichtwellen innerhalb des Lichtwellenleiters und
- Figur 4: die Schaltvorrichtung gemäß Figur 1a in Draufsicht bezogen auf ein X-Y-Koordinatensystem.

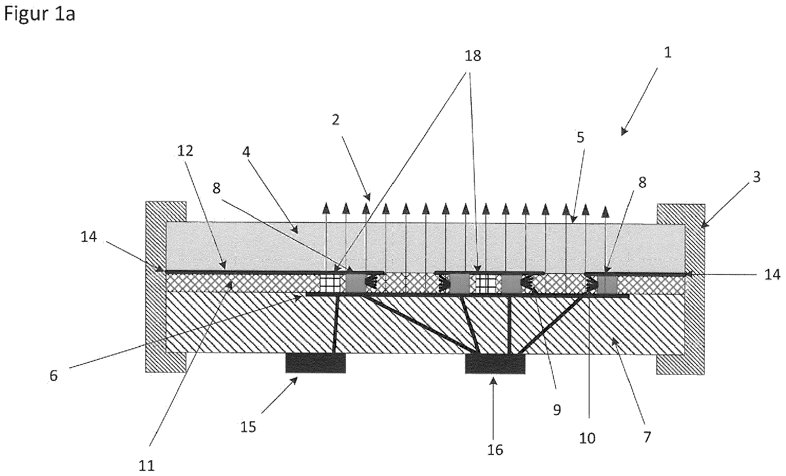

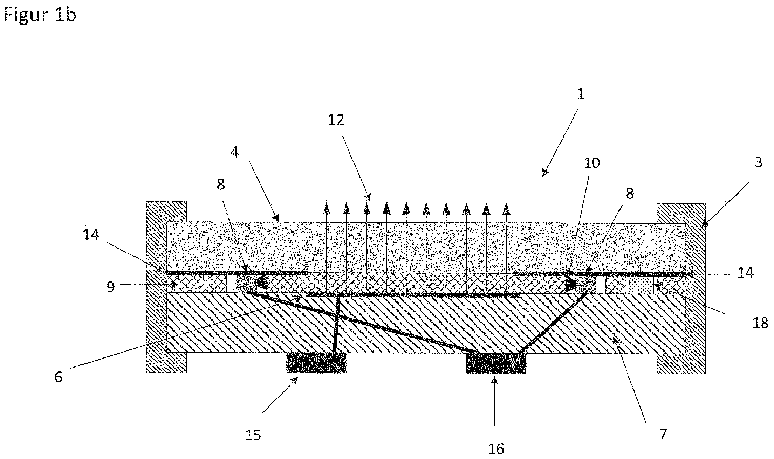

In den Figuren 1a und 1b ist eine kapazitive Schaltvorrichtung 1 zu entnehmen, mit deren Hilfe eine Werkzeugmaschine, ein technisches Gerät, beispielsweise ein Handy, oder dgl. bedient werden soll. Die Schaltvorrichtung 1 besteht dabei aus einem Gehäuse 3, in dem eine Abdeckplatte 4 aus einem transparenten und biegefesten Werkstoff, insbesondere aus Glas oder Kunststoff, eingebaut ist. Die Außenseite der Abdeckplatte 4 bildet dabei eine ebene Begrenzung, die mit einem menschlichen Finger, einem Stift oder sonstigen zur Bedienung geeignete Gegenstände von außen zugänglich ist. Die Abdeckplatte 4 begrenzt daher eine oder mehrere Schaltflächen 5, denen jeweils ein elektrisches Feld 2 zugeordnet ist. Sobald ein menschlicher Finger in das elektrische Feld 2 eindringt, verändert sich dessen Wert und es ist ein elektrisches Schaltsignal generiert, das sowohl punktuell als auch als Bewegung in verschiedene Richtungen auswertbar ist.

Das elektrische Feld 2 wird mittels eines oder mehrerer Sensorflächen 6 aus einem metallischen bzw. elektrisch leitfähigen Werkstoff erzeugt. Die Sensorfläche 6 ist auf einer Trägerplatte bzw. einer Leiterplatte 7 angebracht und zwischen der Sensorfläche 6 und der Unterseite der Abdeckplatte 4 ist ein Innenraum 11 vorgesehen, der derart groß bemessen ist, dass zwischen der Sensorfläche 6 und der Abdeckplatte 4 eine Vielzahl von Beleuchtungsmitteln 8, die vorzugsweise als LED ausgestaltet sind, angeordnet sind. Die Beleuchtungsmittel 8 emittieren Lichtwellen 10 und verlaufen im Wesentlichen parallel und seitlich versetzt zu der jeweiligen Schaltfläche 5. Somit ist die Schaltfläche 5 durch die Beleuchtungsmittel 8 ausgeleuchtet.

Um Reflexionen, Fremdlichteinwirkungen und dgl. zu benachbarten Schaltflächen 5 zu vermeiden, begrenzt jede Reihe der Beleuchtungsmittel 8 eine Reihe von Absorbtionskörper 18, die beispielsweise in Form eines Kondensators, eines Klebers oder einer lichtundurchlässigen Trennwand ausgestaltet sind. Die Absorbtionskörper 18 können unmittelbar auf die Träger- oder Leiterplatte 7 aufgebracht werden, so dass die Bildung von entsprechenden Begrenzungswänden, durch die die von den Beleuchtungsmitteln 8 emittierten Lichtwellen 10 reflektiert oder absorbiert werden, kostengünstig herstellbar ist. Die Kondensatoren als Absorbtionskörper 18 sind elektrisch nicht mit der Leiterplatte 7 verbunden. Die Kondensatoren 18 dienen ausschließlich dazu dienen, die Lichtwellen 10 zu reflektieren und somit innerhalb der jeweiligen Schaltfläche 5 und dem Lichtwellenleiter 9 zu halten.

Die Beleuchtungsmittel 8 sind dabei seitlich im Bereich der Außenkante eines Lichtwellenleiters 9 angeordnet und emittieren die Lichtwellen 10 schräg oder senkrecht in die Stirnseite des Lichtwellenleiters 9, vorzugsweise in einem Winkel von etwa 90°.

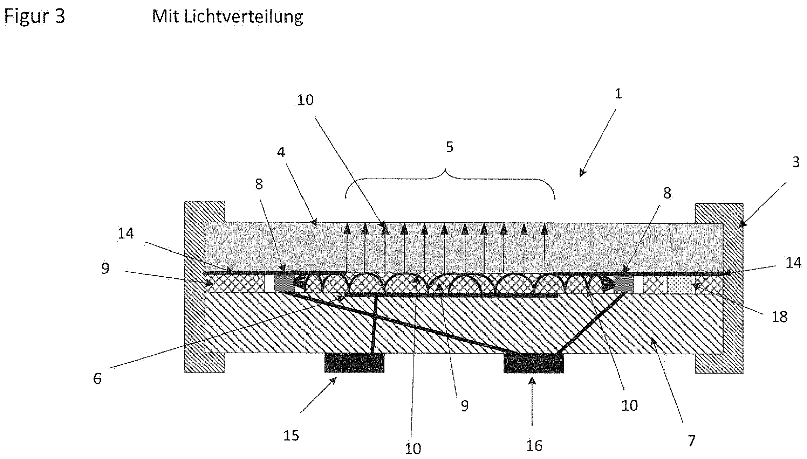

Insbesondere Figur 3 ist dabei zu entnehmen, dass die Lichtwellen 10 von dem Lichtwellenleiter 9 aufgenommen und homogen verteilt sind; von zwei gegenüberliegenden Beleuchtungsmittel 8 ausgesandten Lichtwellen 10 überlagern sich dabei, so dass deren Intensität über die gesamte Fläche des Lichtwellenleiters 9 etwa konstant ist.

In den Figuren 1a und 1b ist weiterhin abgebildet, dass zwischen den Beleuchtungsmitteln 8 bzw. den Lichtwellenleitern 9 und der Unterseite der Abdeckplatte 4 Felder 12 vorgesehen sind, die mit Hilfe einer lichtundurchlässigen Farbe 14 gebildet sind. Zwischen zwei benachbarten Feldern 12 ist ein Freiraum 13 vorgesehen, durch den die von dem Beleuchtungsmitteln 8 emittierten Lichtwellen 10 in Richtung der Schaltfläche 5 der Abdeckplatte 4 gelangen. Auch die Sensorflächen 6 sind reflektierend oder absorbierend ausgestaltet, so dass diese Streuverluste verhindern.

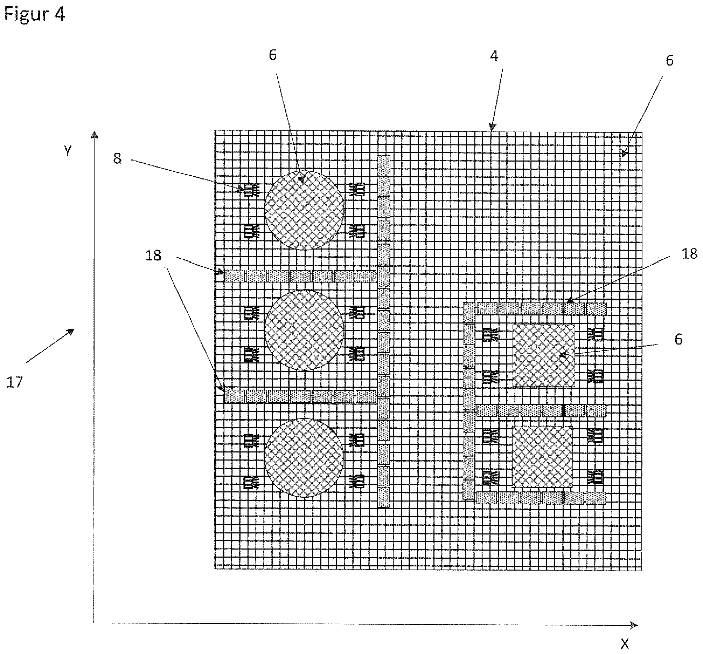

Um die Veränderung des elektrischen Feldes 2 zu erfassen, ist die jeweilige Sensorfläche 6 elektrisch mit einer IC-Sensorauswerteeinrichtung 15, die als integrierter Schaltkreis anzusehen ist, gekoppelt, durch die die Bewegungen des menschlichen Fingers in X- und/oder Y-Richtung gemessen wird. Insbesondere in Figur 4 ist das X-Y-Koordinatensystem 17 gezeigt, das die von der Abdeckplatte 4 gebildete Ebene schematisch darstellt. In Abhängigkeit von der Programmierung der IC-Sensorauswerteeinrichtung 15 kann daher nicht nur eine punktuelle Veränderung des elektrischen Feldes 2 erfasst werden, sondern vielmehr auch eine lineare Bewegung eines menschlichen Fingers über die Schaltfläche 5, und zwar sowohl in X- oder Y-Richtung bzw. in jedem beliebigem Winkel dazwischen.

Die einzelnen Beleuchtungsmittel 8 sind elektrisch mit einer Steuereinrichtung 16 verbunden, durch die die Beleuchtungsmittel 8 ein- oder ausgeschaltet werden können oder die Farbtöne, die von den Beleuchtungsmitteln 8 emittierten Lichtwellen 10 aufweisen sollen, kann mit Hilfe der Steuereinrichtung 16 an den jeweiligen Betriebszustand der Schaltfläche 5 angepasst sein.

Die Absorbtionskörper 18 sind in einer gemeinsamen Ebene mit den Beleuchtungsmitteln 8 und dem Lichtwellenleiter 9, und zwar zwischen der Sensorfläche 6 und der Abdeckplatte 4, angeordnet. Desweiteren umhüllen die Absorbtionskörper 18 die Reihen von Beleuchtungsmitteln 8 derart, dass die von den Beleuchtungsmitteln 8 emittierten Lichtwellen 10 von den Absorbtionskörpern 18 weggerichtet sind.

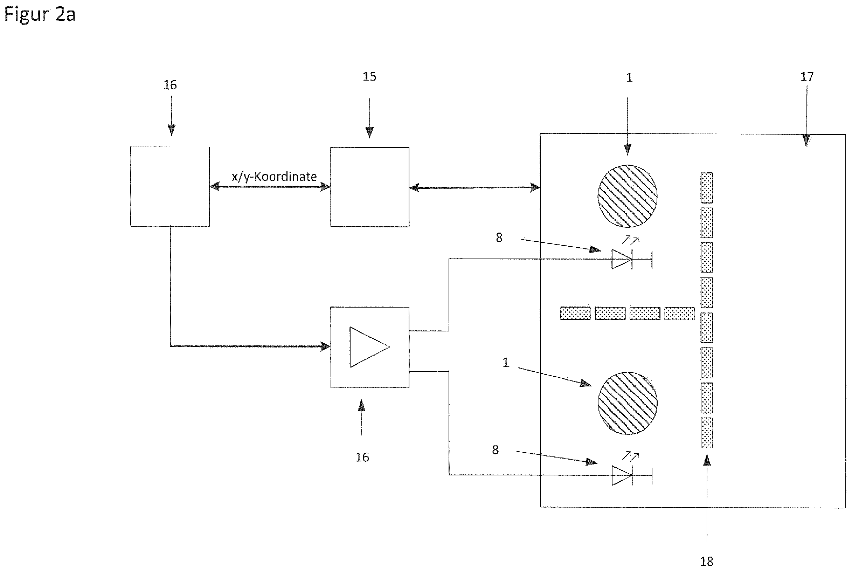

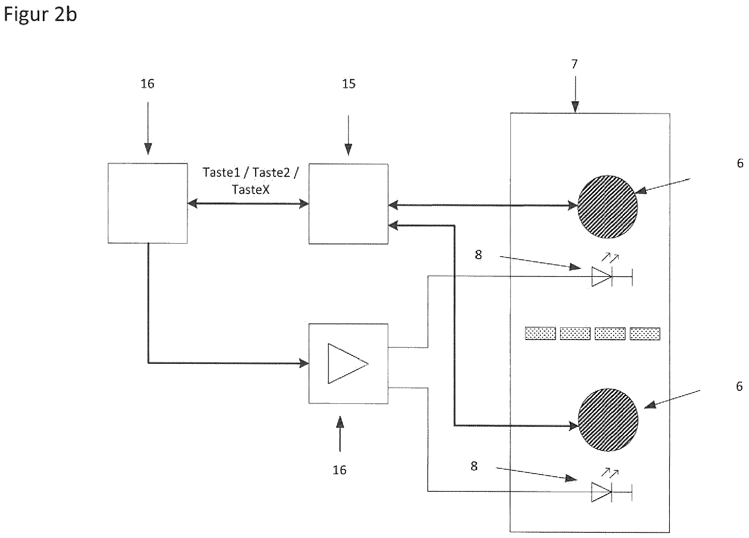

Desweiteren ist den Figuren 2a und 2b zu entnehmen, dass die Schaltflächen 5 beliebige Konturen aufweisen können; diese können daher rund, elliptisch oder mehreckig ausgestaltet sein. Auch die Anordnung der Absorbtionskörper 18 in Bezug auf die Schaltflächen 5 ist nahezu frei wählbar. Es ist jedoch besonders vorteilhaft, wenn die Absorbtionskörper 18 fluchtend zu dem jeweiligen Randbereich der Schaltflächen 5 verlaufen. Dadurch ist gewährleistet, dass die Schaltfläche 5 vollständig durch die Beleuchtungsmittel 8 ausgeleuchtet ist.

Insbesondere in den Figuren 1a, 2a und 2b ist ersichtlich, dass die Sensorflächen 6 auch mit Funktionselementen bestückt werden können. Diese Funktionselemente sind fest an der Sensorfläche arretiert und beispielsweise als Taste, Slider oder als Rad ausgestaltet. Auch kann die erfindungsgemäße Schaltvorrichtung 1 als Touchpad verwendet werden, so dass sowohl punktuelle als auch lineare Bewegungen in Form der Veränderung des elektrischen Feldes von der Auswerteeinrichtung 16 erfassbar sind. Die Auswerteeinrichtung 16 ist dabei als integrierter Schaltkreis auszugestalten und entsprechend zu programmieren, um die punktuellen und/oder die Bewegungen auf der Schaltoberfläche erkennen zu können und daraus das entsprechende elektrische Schaltsignal zu generieren.

## Patentansprüche

1. Kapazitive Schaltvorrichtung (1) zur Erzeugung mindestens eines elektrisch auswertbaren elektrischen Feldes (2),
- mit einer in einem Gehäuse (3) angeordneten Abdeckplatte (4), die aus einem transparenten oder semitransparenten Werkstoff, insbesondere aus Glas oder aus einem biegefesten Kunststoff, hergestellt ist, und durch die mindestens eine von außen zugängliche Schaltfläche (5) gebildet ist,
- mit mindestens einer das elektrische Feld (2) erzeugenden Sensorfläche (6), die aus einem metallischen Werkstoff hergestellt und die im Inneren des Gehäuses (3) und fluchtend zu der jeweiligen Schaltfläche (5) vorgesehen ist,
- und mit mindestens einem in dem Gehäuse (3) angebrachten Beleuchtungsmittel (8), insbesondere einer LED, durch die Lichtwellen (10) erzeugt sind und durch die die Schaltfläche (5) beleuchtet ist,
wobei die Sensorfläche (6) unmittelbar auf einer im Inneren des Gehäuses (3) angeordneten Träger- oder Leiterplatte (7) aufgebracht ist,
**dadurch gekennzeichnet,**
**dass** zwischen der Sensorfläche (6) und der Innenseite der Abdeckplatte (4) ein derart groß bemessener Innenraum (11) vorhanden ist, dass in diesen die Beleuchtungsmittel (8) einbaubar sind, dass durch die Beleuchtungsmittel (8) die Lichtwellen (10) homogen in den Innenraum (11), eingestrahlt sind, dass die jeweilige Sensorfläche (6) eine punktuelle oder flächige Struktur zur Bildung einer vorgegebenen Geometrie aufweist und dass die Sensorfläche (6) elektrisch mit einer IC-Sensorauswerteeinrichtung (15) gekoppelt ist, durch die die Veränderung des von der Sensorfläche (6) erzeugten elektrischen Feldes (2) im Bereich der Schaltfläche aufgrund der Bewegung eines menschlichen Fingers in X- und /oder in Y-Richtung bezogen auf das X-Y-Koordinatensystem der Schaltfläche (5) erfassbar sind.

2. Schaltvorrichtung nach Anspruch 1,
**dadurch gekennzeichnet,**
**dass** zwischen der jeweiligen Sensorfläche (6) und der Abdeckplatte (4) mindestens ein Lichtwellenleiter (9) eingebaut ist und dass die Beleuchtungsmittel (8) seitlich neben dem Lichtwellenleiter (9) angebracht sind und die Lichtwellen (10), vorzugsweise in einem Winkel von etwa 90°, schräg oder senkrecht in den Lichtwellenleiter (9) eingestrahlt sind.

3. Schaltvorrichtung nach Anspruch 2,
**dadurch gekennzeichnet,**
**dass** durch die Lichtwellenleiter (9) die von den Beleuchtungsmitteln (8) emittierten Lichtwellen (10) aufgenommen und homogen im Bereich der jeweiligen Schaltfläche (5) verteilt sind.

4. Schaltvorrichtung nach einem der vorgenannten Ansprüche,
**dadurch gekennzeichnet,**
**dass** zwischen zwei benachbarten Schaltflächen (5) lichtundurchlässige Absorbtionskörper (18), vorzugsweise in Form von Kondensatoren, Klebern oder Trennwänden, auf der Träger- oder Leiterplatte (7) angebracht sind, durch die die von den Beleuchtungsmitteln (8) erzeugten Lichtwellen (10) reflektiert oder absorbiert sind.

5. Schaltvorrichtung nach Anspruch 4,
**dadurch gekennzeichnet,**
**dass** die Absorbtionskörper (18), die Beleuchtungsmittel (8) und die Lichtwellenleiter (9) in einer Ebene angeordnet sind und dass die Absorbtionskörper (18) benachbart zu den Beleuchtungsmitteln (8) in einer Reihe angeordnet sind und dass die von den Beleuchtungsmitteln (8) ermittelten Lichtwellen (10) gegenüberliegend zu den Absorbtionskörpern (18) verlaufen.

6. Schaltvorrichtung nach einem der vorgenannten Ansprüche,
**dadurch gekennzeichnet,**
**dass** unmittelbar auf der dem Innenraum (11) zugewandten Unterseite der Abdeckplatte (4) eine oder mehrere Felder (12) mit einer Farbe (14) beschichtet oder bedruckt sind und dass die derart geschaffenen Felder (12) die von den Beleuchtungsmitteln (8) erzeugten Lichtwellen (10) reflektieren oder absorbieren, und dass zwischen zwei benachbarten Feldern (12) ein Freiraum (13) vorgesehen ist, durch den die von den Beleuchtungsmitteln (8) erzeugten Lichtwellen (10) in Richtung der Abdeckplatte (4) austreten.

7. Schaltvorrichtung nach Anspruch 6,
**dadurch gekennzeichnet,**
**dass** der jeweilige Freiraum (13) fluchtend zu einem der Lichtwellenleiter (9) angeordnet ist und dass die Felder (12) fluchtend zu dem Absorbtionskörper (18) ausgerichtet sind.

8. Schaltvorrichtung nach Anspruch 7,
**dadurch gekennzeichnet,**
**dass** der Freiraum (13) zwischen zwei benachbarten Feldern (12) die jeweilige beleuchtete Schaltfläche (5) bildet.

9. Schaltvorrichtung nach einem der vorgenannten Ansprüche,
**dadurch gekennzeichnet,**
**dass** die jeweilige Sensorfläche (6) lichtundurchlässig oder lichtreflektierend ist.

10. Schaltvorrichtung nach Anspruch 9,
**dadurch gekennzeichnet,**
**dass** durch eine elektrische Steuervorrichtung (16), vorzugsweise einen Mikrocontroller, Mikroprozessor oder einen integrierten Schaltkreis, die jeweiligen Beleuchtungsmittel (8) elektrisch verbunden sind und dass in Abhängigkeit von den gemessenen bzw. erfassten Veränderungen des elektrischen Feldes (2) auf der Schaltfläche (5) der Abdeckplatte (4) die Beleuchtungsmittel (8) durch die elektrische Steuereinrichtung (16) derart geschaltet sind, dass die Farbe der Lichtwellen (10) veränderbar ist oder dass die Beleuchtungsmittel (8) aus- bzw. eingeschaltet sind.

11. Schaltvorrichtung nach einem der vorgenannten Ansprüche,
**dadurch gekennzeichnet,**
**dass** auf der jeweiligen Sensorfläche (6) ein Funktionselement, beispielsweise eine Taste, ein Slider oder ein Rad, arretiert ist.

## Claims

1. A capacitative circuit (1) for generating at least one electrical field which can be evaluated
- with a cover plate (4) manufactured from a transparent or semi-transparent material, in particular from glass or a flexurally rigid polymer arranged in a housing (3), and by means of which at least one switching area (5) accessible from the outside is formed,
- with at least one sensor area (6) generating the electrical field (2), which is manufactured from a metallic material and which is provided inside the housing (3) and is flush with the corresponding switching area (5),
- and with at least one means of illumination (8), in particular an LED, attached within the housing (3) by means of which light waves (10) are generated and by means of which the switching area (5) is illuminated,
in which the sensor area (6) is directly applied to a carrier plate or circuit board (7) arranged within the housing (3),
**characterised in that**,
between the sensor area (6) and the inside of the cover plate (4), there is an interior space (11) which is sufficiently large to allow the means of illumination (8) to be installed in it, that the means of illumination (8) shines the light waves (10) into the interior space (11) homogenously, that the particular sensor area (6) has an interrupted or full-surface structure in order to form the specified geometry and that the sensor area (6) is electrically connected to an IC sensor evaluation device (15) by means of which the change in the electrical field (2) in the area of the switching area due to the movement of a human finger in the X and/or Y-direction in relation to the X/Y coordinate system of the switching area (5) can be detected by the sensor area (6).

2. The capacitative circuit in accordance with Claim 1,
**characterised in that**,
at least one fibre-optic cable (9) is installed between the particular sensor area (6) and the cover plate (4) and that the means of illumination (8) is attached on the side adjacent to the fibre-optic cable (9) and the light waves (10) are shone into the fibre-optic cable (9) either at an angle or perpendicular, preferably at an angle of about 90°.

3. The capacitative circuit in accordance with Claim 2,
**characterised in that**,
the fibre-optic cable (9) receives the light waves (10) emitted by the means of illumination (8) and distributes them homogenously in the area of the particular switching area (5).

4. The capacitative circuit in accordance with one of the aforementioned claims,
**characterised in that**,
absorption bodies (18) which are not permeable to light, preferably in the form of capacitors, glue spots or partition walls, are attached to the carrier plate or circuit board (7) between two adjacent switching areas (5), by means of which the light waves (10) generated by the means of illumination (8) are reflected or absorbed.

5. The capacitative circuit in accordance with Claim 4,
**characterised in that**,
the absorption bodies (18), the means of illumination (8) and the fibre-optic cable (9) are arranged in one plane and that the absorption bodies (18) are arranged adjacent to the means of illumination (8) in a row and that the light waves (10) generated by the means of illumination (8) run opposite to the absorption bodies (18).

6. The capacitative circuit in accordance with one of the aforementioned claims,
**characterised in that**,
one or more fields (12) are coated with a paint (14) or printed directly on the underside of the cover plate (4) facing towards the interior space (11) and that the fields (12) created in this way reflect or absorb the light waves (10) generated by the means of illumination (8), and that the between two adjacent fields (12) a cavity (13) is provided through which the light waves (10) generated by the means of illumination (8) emerge in the direction of the cover plate (4).

7. The capacitative circuit in accordance with Claim 6,
**characterised in that**,
the particular cavity (13) is arranged flush with one of the fibre-optic cables (9) and that the fields (12) are aligned flush with the absorption body (18).

8. The capacitative circuit in accordance with Claim 7, **characterised in that**,
the cavity (13) between two adjacent fields (12) forms the particular illuminated switching area (5).

9. The capacitative circuit in accordance with one of the aforementioned claims,
**characterised in that**,
the particular sensor area (6) is non-permeable to light or reflective to light.

10. The capacitative circuit in accordance with Claim 9,
**characterised in that**,
the particular means of illumination (8) is electrically connected by an electrical control device (16), preferably a microcontroller, microprocessor or an integrated circuit, and that depending on the measured or registered changes in the electrical field (2) on the switching area (5) of the cover plate, the means of illumination (8) is switched in such a way by the electrical control device (16) that the colour of the light waves (10) can be changed or that the means of illumination (8) is switched off or on.

11. The capacitative circuit in accordance with one of the aforementioned claims,
**characterised in that**,
a functional element, for example a key, a slider or a wheel, is locked onto the particular sensor area (6).

## Revendications

1. Dispositif de commutation capacitif (1) servant à la génération d'au moins un champ électrique utilisable (2),
- avec une plaque de recouvrement (4) disposée dans un boîtier (3) et réalisée en matériau transparent ou semi-transparent, en particulier en verre ou en matière synthétique résistant à la flexion, et qui forme au moins une face de commutation (5) accessible de l'extérieur,
- avec au moins une face de capteur (6) générant le champ électrique (2), réalisée en matériau métallique et prévue à l'intérieur du boîtier (3) ainsi qu'en alignement précis sur la face de commutation respective (5),
- et avec au moins un moyen d'éclairage (8), notamment une DEL, prévu dans le boîtier (3) qui produit des ondes lumineuses (10) et qui éclaire la face de commutation (5),
la face de capteur (6) étant montée directement sur une platine de support ou conductrice (7) disposée à l'intérieur du boîtier (3),
**caractérisé en ce que**,
entre la face de capteur (6) et la face intérieure de la plaque de recouvrement (4), il est prévu un espace (11) assez grand pour recevoir les moyens d'éclairage (8), que les moyens d'éclairage (8) assurent le rayonnement homogène des ondes lumineuses (10) vers l'intérieur (11), que la face de capteur respective (6) possède une structure ponctuelle ou plane servant à la formation d'une géométrie définie, et que la face de capteur (6) est raccordée électriquement à un équipement d'évaluation CI (15), par lequel il se laisse saisir le changement du champ électrique (2) généré par la face de capteur (6) sur la face de commutation en raison du déplacement d'un doigt humain en direction X et/ou Y, référé au système de coordonnées X-Y de la face de commutation (5).

2. Dispositif de commutation d'après la revendication 1,
**caractérisé en ce que**,
entre la face de capteur respective (6) et la plaque de recouvrement (4), il est prévu au moins un conducteur d'ondes lumineuses (9), que les moyens d'éclairage (8) sont prévus sur le côté du conducteur d'ondes lumineuses (9), et que les ondes lumineuses (10) sont rayonnées dans le conducteur d'ondes lumineuses (9) de préférence sous un angle d'env. 90°, en biais ou perpendiculairement.

3. Dispositif de commutation d'après la revendication 2,
**caractérisé en ce que**
les ondes lumineuses (10) émises par les moyens d'éclairage (8) sont reçues par les conducteurs d'ondes lumineuses (9) et distribuées de manière homogène sur la face de commutation (5).

4. Dispositif de commutation d'après une des revendications précédentes,
**caractérisé en ce que**,
entre deux faces de commutation voisines (5), il est prévu sur la platine de support ou conductrice (7) des corps d'absorption opaques (18), de préférence sous la forme de condensateurs, de colles ou de parois de séparation, qui assurent la réflexion ou l'absorption des ondes lumineuses (10) générées par les moyens d'éclairage (8).

5. Dispositif de commutation d'après la revendication 4,
**caractérisé en ce que**
les corps d'absorption (18), les moyens d'éclairage (8) et les conducteurs d'ondes lumineuses (9) sont disposés dans un plan, que les corps d'absorption (18) sont disposés en ligne au voisinage des moyens d'éclairage (8) et que les ondes lumineuses (10) saisies par les moyens d'éclairage (8) se trouvent en face des corps d'absorption (18).

6. Dispositif de commutation d'après une des revendications précédentes,
**caractérisé en ce que**
sur la face inférieure de la plaque de recouvrement (4) donnant sur l'intérieur (11), un ou plusieurs champs (12) sont recouverts directement ou imprimés avec de la peinture (14), et que les champs ainsi réalisés (12) reflètent ou absorbent les ondes lumineuses (10) générées par les moyens d'éclairage (8), et qu'entre deux champs voisins (12), il est prévu un espace libre (13) par lequel s'échappement les ondes lumineuses (10) générées par les moyens d'éclairage (8) en direction de la plaque de recouvrement (4).

7. Dispositif de commutation d'après la revendication 6,
**caractérisé en ce que**
l'espace libre respectif (13) se trouve en alignement précis sur un des conducteurs d'ondes lumineuses (9) et que les champs (12) sont en alignement précis sur le corps d'absorption (18).

8. Dispositif de commutation d'après la revendication 7,
**caractérisé en ce que**
l'espace libre (13) entre deux champs voisins (12) constitue la face de commutation respective éclairée (5).

9. Dispositif de commutation d'après une des revendications précédentes,
**caractérisé en ce que**
la face de capteur respective (6) est opaque ou réfléchissant la lumière.

10. Dispositif de commutation d'après la revendication 9,
**caractérisé en ce que**
les moyens d'éclairage respectifs (8) sont raccordés électriquement par un dispositif de commande électrique (16), de préférence un microcontrôleur, un microprocesseur ou un circuit intégré et qu'en dépendance des changements du champ électrique mesurés ou saisis (2), les moyens d'éclairage (8) sur la face de commutation (5) de la plaque de recouvrement (4) sont commutés par le dispositif de commande électrique (16) de sorte qu'il soit possible de changer la couleur des ondes lumineuses (10) ou que les moyens d'éclairage (8) soient désactivés ou activés.

11. Dispositif de commutation d'après une des revendications précédentes,
**caractérisé en ce que**
sur la face de capteur respective (6), il est positionné un élément fonctionnel, p. ex. une touche, une glissière ou une roue.
